# EUROPEAN PATENT APPLICATION

(11) **EP 2 902 792 A1**
(43) Date of publication of application: **05.08.2015**
(21) Application number: 15153487.2
(22) Date of filing: 02.02.2015
(51) Int. Cl.: G01R 22/06

(54) **Power measurement**

(30) Priority: 03.02.2014 GB 201401758
(71) Applicant: Ivy Limited, Buckinghamshire MK13 9AP (GB)
(72) Inventor: Brett, David, Milton Keynes, Buckinghamshire MK14 5DS (GB)
(74) Representative: Turner, Richard Charles

(57) **Abstract**

A power measurement system comprises a sensor 18 and a system manager 26. The sensor 18 is arranged to detect the waveform of the current in a connection 12 and to transmit the detected current waveform and timing information for the current waveform. The system manager 26 is arranged to receive the detected current waveform and timing information for the current waveform, detect the waveform of the voltage in a network 16, and preferably determine the magnitude (as a real power measurement) and direction of the energy flow in the connection 12 from the detected current waveform in the connection 12 and the detected voltage waveform in the network 16.

## Description

This invention relates to a power measurement system. In a preferred embodiment, the invention provides non-invasive sensing of real power over a wireless link.

Global warming has made everyone more aware of a likely future with continually rising energy prices. To combat increasing costs people will need to be more efficient in their use of energy and the first step to doing this is the ability to better measure energy use. The typical electricity meter provides an accurate means of measuring energy used at the point of supply over a period of time but better control over use of energy requires the monitoring of its use instantaneously and at many more points in the electrical system. The growth in the use of local generation and renewable energy makes this requirement even more imperative.

The world is changing and the way in which consumers expect things to work is changing too. More and more people expect to use tablets or smartphones for everyday experiences. People do not want to mess around in dark cupboards or crawl on the floor to read meters and, as far as possible in a time poor world, people want everything to be automatic.

It is therefore an object of the invention to improve upon the known art.

According to a first aspect of the present invention, there is provided a power measurement system comprising a sensor arranged to detect the waveform of the current in a connection and to transmit the detected current waveform and timing information for the current waveform, and a system manager arranged to receive the detected current waveform and timing information for the current waveform, detect the waveform of the voltage in a network, and determine the magnitude of the energy flow in the connection as a real power measurement from the detected current waveform in the connection and the detected voltage waveform in the network.

According to a second aspect of the present invention, there is provided a power measurement method comprising detecting the waveform of the current in a connection with a sensor, transmitting the detected current waveform and timing information for the current waveform, receiving the detected current waveform and timing information for the current waveform at a system manager, detecting the waveform of the voltage in a network, and determining the magnitude of the energy flow in the connection as a real power measurement from the detected current waveform in the connection and the detected voltage waveform in the network.

Owing to the invention, it is possible to provide a low cost method to remotely measure and monitor the magnitude of power flow in an electrical system without the need to cut into the connection at each point where power is being sensed. The magnitude of both the real power and the apparent power can also be determined along with the direction of the power flow. Furthermore, all this can be achieved over a wireless link.

In a preferred embodiment, the innovative steps are in the methods and combination of methods used, particularly wireless capability enabled by time stamping and the use of polarity sensing at the sensor to enable a system manager to determine the magnitude of the real power, power factor, the non-invasive capability, an algorithmic method to identify the sensor orientation on the sensing point conductor, an adaptive control to reduce the accuracy requirement and cost of the sensor, the use of phase control or PWM to match the load to surplus power generated to avoid unwanted metering effects and the ease of installation while still complying with the wiring regulations.

Energy and building management systems must have the ability to take multiple measurements of power usage that correlate with metered charges and communicate with the modern wave of Internet enabled systems to access other relevant information. The following features enable the sensor to achieve these aims.

Real power measurement, as used by the system, is the same as the method used to calculate electricity bills. Many systems measure apparent power that does not correlate with the amount metered and charged for the electricity used. The system uses wireless communication to reduce the cost of installation, collect the results of multiple measurements in a central unit and present the results in a simple app on a tablet, smart phone or similar device. The system can also measure the direction of power flow so it is ideally suited to use in installations that also generate their own local power. The direction of the energy flow in the connection can be calculated from the timing difference between the detected current waveform in the connection and the detected voltage waveform in the network.

The sensors are non-invasive. The circuit being measured does not have to be rewired. All that is needed is the ability to clip the sensor around one of the conductors in the supply. This is ideal for loads that are wired in such as storage heaters and high power loads like electric cookers. Meters do not provide an indication of the instantaneous use of energy but only how much is consumed over a period of time so the ability to measure the instantaneous use of electricity is crucial to control and manage a modern electrical installation. This is why systems need their own sensors that are capable of making measurements in real time.

The non-invasive technology and wireless capabilities of the sensor make it an ideal choice to centralise the management of multiple points in an electrical system at a lower cost than installing traditional electricity meters at every location where energy monitoring is desired.

The random nature of renewable energy means that most renewable power generators will use power from the Grid (the national, central electricity supply system) when their own power is not sufficient for their immediate needs but at other times will have surplus power. The local power generator can save money if the surplus power can be used locally to replace other, more expensive power. This can be done by storing the surplus power for use at a later time when local power isn't sufficient or by using it for other purposes. Typical examples would be the use of surplus power to heat water, in electric storage heaters or in an automotive charging station. Smaller installations, such as a home using solar panels and/or a wind turbine, do not produce much surplus power. They require a low cost system to provide a financial return on the use of surplus power. The power flow capabilities of the sensor provide a means of diverting locally generated, surplus energy to storage on a completely automatic basis using just one of the new sensors.

The wireless technology used in the sensor is ideally suited to providing components that can provide central control of electrical and non-electrical loads. In many cases the components can be designed to work without batteries providing long term, low maintenance, environmentally friendly systems. A system can be created with multiple components that is ideally placed to take advantage of upcoming industry standards, the proposals for smart metering and access to on-line services to make optimum use of energy tariffs and to provide other capabilities not currently available. For example, a single system can provide on-line control and monitoring of all building services including the measurement and control of lighting, audio-visual systems, domestic heating, security and air conditioning. Tablets are already used to control Home Cinema systems, for example. The improved sensor and compatible components extend this functionality to other in-home services and commercial and industrial buildings.

Power factor is a measure of the efficiency of a power system. Low power factor systems draw more current for the same amount of useful power transferred. The higher current increases the cost to provide the power as losses increase and higher rated equipment is required. Therefore, most installations are designed to operate near unity power factor.

When systems include local power generators they may produce DC power that requires an inverter to convert the power to the usual AC standard or they may produce AC power that needs to be synchronised to the local installation. Either way, in order to cause power to be exported back to the Grid, the inverter or equivalent device will go through a state where it appears capacitive or inductive to the system. In other words, the system is no longer operating at unity power factor.

An inverter is unlikely to have a significant effect on the power factor of an installation when there is a significant amount of Grid power flow (more than about 500 Watts). But when Grid power flow is near zero, the inverter does not appear as purely resistive. It may control the power flow by a change in the phase angle of the Grid current without, necessarily, any change in the Grid current magnitude. It may also act in such a way as to increase harmonic currents. Some inverters produce regular distortions over several mains cycles. To eliminate these distortions the sensor can take measurements over several cycles and average the result.

One method of detecting the direction of power flow is to directly measure it at the sensing point. Measuring the direction of power flow as well as the amount requires that the power factor at the sensing point is determined. A sensor is required that directly measures both voltage and current. It will usually require calibration and it will incorporate a computational ability to calculate the amount being exported separately to any amounts being imported. The problem with this is that sophisticated sensors are needed to accurately measure both voltage and current, and they are relatively high cost and need to be connected to the mains supply. They need a higher level of expertise to install and commission thus increasing an already high cost.

To find the direction of power flow an algorithmic method can be used. By monitoring the effect of a change in a known local load on the magnitude of the power at a common point in the installation it is possible to identify the direction of power flow. The power taken by a local, controlled load is changed by a small increment (A). This will change the amount of power flow at the common point by the same amount (B). If prior to the change power was flowing from the common point towards the controlled load and there is an increase in the amount taken by the controlled load, then the amount of power flowing towards the controlled load from the common point will increase by the same amount. However, if prior to the change power was flowing away from the common point and there is an increase in the amount taken by the controlled load, then the amount of power flowing away from the common point will decrease by the same amount.

Similarly, if prior to the change power was flowing away from the common point and there is a decrease in the amount taken by the controlled load, then the amount of power flowing away from the common point will decrease by the same amount. And, if prior to the change power was flowing away from the common point and there is a decrease in the amount taken by the controlled load, then the amount of power flowing away from the common point will increase by the same amount. Thus:
A = B if power is flowing from the common point towards the load
A = -B if power is flowing away from the common point

This approach works well when there is significant current flow as the system will be operating near unity power factor and the current measured is a good representation of power flow. But, in some applications such as surplus energy diversion, the optimum state is where power is reduced to at or near zero and as noted above, if an inverter is involved, the apparent current measurement at or near zero power is no longer a good representation of power flow. A potential solution is to use a much larger, incremental change in the controlled load when measuring the change in the magnitude of the current at the common point. If the controlled load has a unity power factor and draws a large enough current it will reduce the effect of the Inverter on the power factor. But using a large increment makes the system less efficient. The key to overcoming the problem is to be able to determine the power factor at the sensor.

One solution is to directly measure both voltage and current and their relative phase angle at the sensor. This will allow the power factor to be calculated to provide the direction of power flow. Measuring current directly is possible but means the sensor is no longer non-invasive. Some form of resistance is required and this leads to a loss in efficiency when larger loads are involved. This approach can also be difficult to protect against overload, especially when high fault currents are possible. In general, direct current measurement is only sensible for smaller loads. However this problem is relatively easily solved by using indirect current measurement with a Hall Effect sensor or a current transformer that is clipped around one wire of the existing current carrying cable. This approach still requires a knowledge of the voltage at the sensing point which again means that fitting the sensor is no longer non-invasive thus losing the cost reduction from ease of installation. Similarly, even if a direct voltage measurement can be determined it still costs more to provide the processing capability in the sensor for it to calculate real power.

However, the main unit that receives the measurements has ready access to the voltage characteristics of the system. The voltage waveform measured at the main unit is not significantly different to that measured elsewhere in the system for the purpose of calculating the phase angle between the voltage and current at the sensing point. Thus, measuring the phase angle or timing difference between the current waveform measured at the sensor and the voltage waveform at the main unit enables the power factor at the sensor to be determined by the main unit. To determine the direction of power flow the sensor also has to sense the polarity of the current waveform it is measuring. The current measurement is converted by an analogue to digital converter chip and is therefore fully rectified so has no polarity. The polarity of the current measured is simply determined using a diode on the current waveform prior to rectification. This is simple to achieve and has no cost implications. The main unit now has enough information to calculate the power factor and direction of the power flow at the sensor.

The simple change to the sensor circuit that enables the polarity of current to be detected unfortunately now means that the system becomes sensitive to the sensor orientation, i.e. which way round the sensor is clipped around the wire at the sensing point. If it is located the wrong way round then the power factor calculation will be 180 degrees out and the system will indicate that the power flow is in the opposite direction to that expected. In many cases the direction of power flow is self-evident so that this is not a problem. But when measuring whether or not power is being imported or exported to the Grid in an energy diversion scenario (see below for the discussion of surplus energy diversion) it is important to get this right.

While it would be possible to manufacture a sensor marked in such a way as to identify which side should be nearest the Grid connection when it is clipped around a Grid conductor this is still prone to installation error. The ideal solution would be for the system to establish polarity of the sensor automatically.

The algorithmic method mentioned above enables the system to easily identify which way round the sensor is clipped around a Grid conductor. Once it is determined which way round the sensor is clipped then the power factor can be calculated directly. Once the power factor is known, the algorithmic method is no longer needed to determine the direction of power flow. Thus the algorithmic method only needs to be used occasionally so the loss of efficiency, one of the limitations of the algorithmic method, is not of concern.

If the sensor in an energy diversion system is for any reason removed and replaced the opposite way round the system can be put into a state where it consumes energy instead of diverting it. Therefore whenever the system output exceeds a threshold, say 90%, the algorithmic method is invoked to check which way round the sensor is installed.

The sensing element is a major cost driver in a measuring system. However, the lowest cost sensor may not be the best solution. A wireless sensor is technically more difficult to realise and increases costs but confers major competitive advantages to a system by the reduced cost of installation. The cost of a wireless sensor can also be mitigated by using its characteristics to enable the sensor to work without batteries thus reducing maintenance and increasing the overall efficiency of the system. The real challenge with a wireless sensor is the need to be able to measure real power.

The traditional approach to using a wireless sensor to measure real power and direction of flow would be to determine the phase angle and power factor at the sensor then send the results by wireless to a system manager. But to do this the sensor needs to do the calculations locally and the energy to do this makes it difficult to have an energy harvesting sensor with no batteries. The required solution needs the ability to transmit the minimum required information by wireless without local calculation and without losing the inherent information required to determine real power and its direction of flow.

The system manager can calculate the phase angle between the current and voltage waveforms if it knows the time at which the current measurement is made a simple but accurate clock in the sensor is used to time stamp the signal carrying the current measurements with the time elapsed between each current measurement and the sending of the signal. The signal also includes the polarity of the current measured. The system manager now has sufficient information to be able to determine the voltage on the system at the time the current measurements were made and hence the power factor. Note that the absolute time at the sensor is not required and the time lag in sending the signal over a wireless link is not significant. The time elapsed can cover several tens of mains cycles due to the time required to process the signal. The main unit can eliminate the time taken by whole cycles from the measurement to arrive at the time at which the voltage measurement corresponding to the current measurement is taken. However, the time eliminated for the whole cycles depends on the mains frequency. Therefore the main unit maintains an accurate measurement of the mains frequency in order to ensure the time eliminated is sufficiently accurate. The system manager of the main unit measures the mains frequency of the voltage in the network and adapts the timing information accordingly.

Accurate, low cost clock chips are available and would be effectively included free if a wireless transmitter is in use so the extra cost added to the sensor is minimal compared to the cost of measuring and calculating the voltage at the sensor.

To increase accuracy, two signals can be sent to the system manager a known, accurate time apart. The first signal primes the system manager to receive the second signal so the system manager can accurately record the time of arrival of the second signal.

Suitable current sensing and radio transmitting systems can be self-powered from the supply they are monitoring providing the significant benefit of not requiring batteries. They harvest energy from the current flow being measured by the sensor.

Sometimes there may be little or no current flow at the sensing point so the sensing system will not be able to obtain enough power for its normal measurement operation. The sensor can indicate this state to a system manager by simply sending it a low power "keep alive" signal. A keep alive signal requires very little power and indicates that the current measurement hasn't changed significantly but the system manager can still determine small changes in the magnitude of the current being sensed by monitoring the frequency of the keep alive signals. The sensor is in a very low power mode so energy harvesting will be sufficient even with very low currents. By receiving "keep alive" signals the system manager knows that the sensor is working. This enables the direction and magnitude of the power flow to be ascertained even at low levels of current whilst still achieving the desired cost reduction. When a significant event occurs that alters the system state then the sensor will be able to transmit a measurement to the main unit straightaway. The change in current that a significant event will cause ensures that the sensor will have enough energy to send a full measurement to the main unit.

Sometimes, such as at night, nothing changes and the current flow through the common point may not be enough to provide even the minimal power required for a "keep alive" signal. When a "keep alive" signal has not been received for say, an hour, then the system manager uses a watchdog function to deliberately generate a current flow through the common point by momentarily altering the controlled load. This will be a significant event to which the sensor must respond and send a measurement. No response indicates a system failure.

When a wireless solution is in use there are some other features required to ensure the wireless connection is working properly.

For the transmitting unit, during installation when deciding where to site the system manager the system needs to show that the wireless communication is working and not being blocked. This is ascertained by indicators on the sensor and system manager. Each sensor has a small LED indicator that blinks whenever a radio transmission is made. If a sensor is attached to a conductor but does not blink at least every ten seconds then the sensor is faulty or there is not enough power flow in the conductor to which the sensor is attached for it to harvest enough energy to operate. For a new system, a load, such as an electric kettle, may need to be turned on so the sensor can harvest enough energy to operate. Its LED indicator will blink to show it is transmitting and will be detected by any system manager within reach of the transmitted signal.

For the receiving unit, the system manager will indicate that it has detected the presence of a new sensor. This allows confirmation during installation that the system manager is in a location where the sensor radio transmissions can be 'heard'. The system manager only requires a simple connection to the mains power supply to carry out this check. It does not need to have a connection to a controlled load at this point.

The system manager can have a single, designated key sensor. The key sensor is the one that is used for detecting the direction of power flow and so is affected by changes in the controlled load. The keep alive process will apply to this key sensor. The system manager will check if the sensor responds to changes in the controlled load in a similar manner to the operation of the watchdog function. This will also automatically confirm that the sensor is on the correct phase of the installation. If the check is passed then the sensor will register automatically with the system manager as its key sensor. It will replace any previous key sensor that may have previously been registered. If the previous key sensor still exists or other key sensors are detected then an error condition will be indicated. Additional wireless sensors can operate with the system manager. Additional sensors transmit a key value to the system manager so it can identify them as being compatible sensors. They will automatically register as auxiliary sensors provided they are first used within a pre-determined time period, say three minutes, after the system manager is powered up. This avoids registration of compatible sensors in operation nearby on other systems. Note that this restriction does not apply to key sensors. The function of registered, auxiliary sensors is then determined using the tablet or smart phone app.

Embodiments of the present invention will now be described, by way of example only, with reference to the accompanying drawings, in which:-
Figure 1 is a schematic diagram of a prior art surplus power storage system,
Figure 2 is a schematic diagram of surplus power storage system according to an embodiment of the invention,
Figure 3 is a schematic diagram of the exterior of a main unit of the surplus power storage system of Figure 2,
Figure 4 is a schematic diagram of the components of a system manager of the surplus power storage system of Figure 2,
Figure 5 is a process diagram of the method of operating the surplus power storage system,
Figure 6 is a diagram illustrating the concept of phase angle,
Figure 7 is a diagram of two graphs showing power increments to be used dependent on time delays between sensor measurements in different scenarios, and
Figure 8 is a schematic diagram of a building control system.

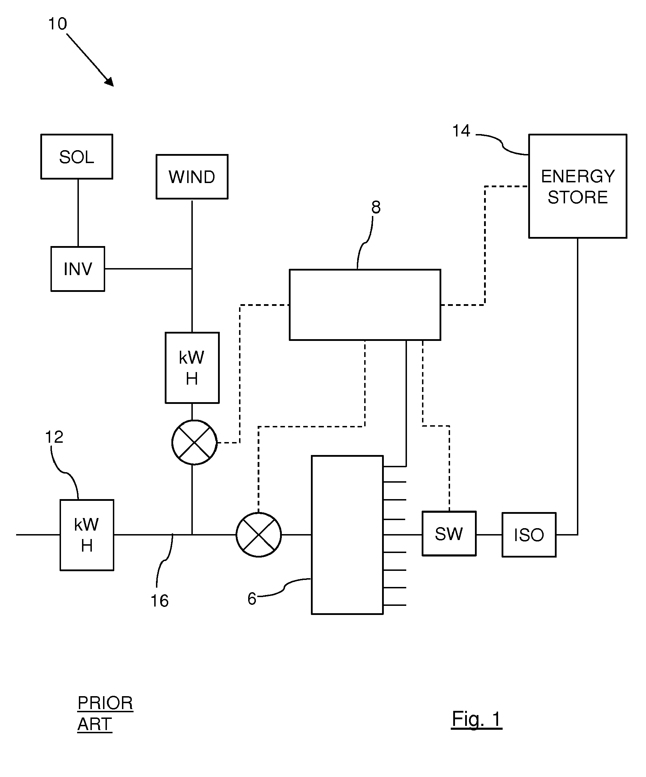

The benefit of the new system can be seen by comparing a current energy diversion solution with one using the components available in the new system concept. An existing approach to finding out the amount of surplus power is to use one sensor to measure the power used locally and a separate sensor to measure the power generated locally. Figure 1 shows an example of such a prior art system. Local power generators 10 (a solar panel connected through an inverter and a wind turbine) provide power as does the connection 12 to the general power grid. An energy store 14, which can be used to store surplus power, is provided and the various components are connected together via a network 16. By subtracting one from the other, the surplus power is calculated by a unit 8, which is powered off the distribution board 6. The unit 8 is connected to two sensors and a switch located after the board 6 and before an isolator. Alternatively, a more complex, single sensor that is capable of measuring power flow exported to the Grid can be used to measure surplus power directly. Surplus power is then diverted to another, local use such as an immersion heater or a storage heater. Such a system requires one or more, accurate, fast, power flow sensors and a sophisticated computing element plus installation by an appropriate, skilled expert.

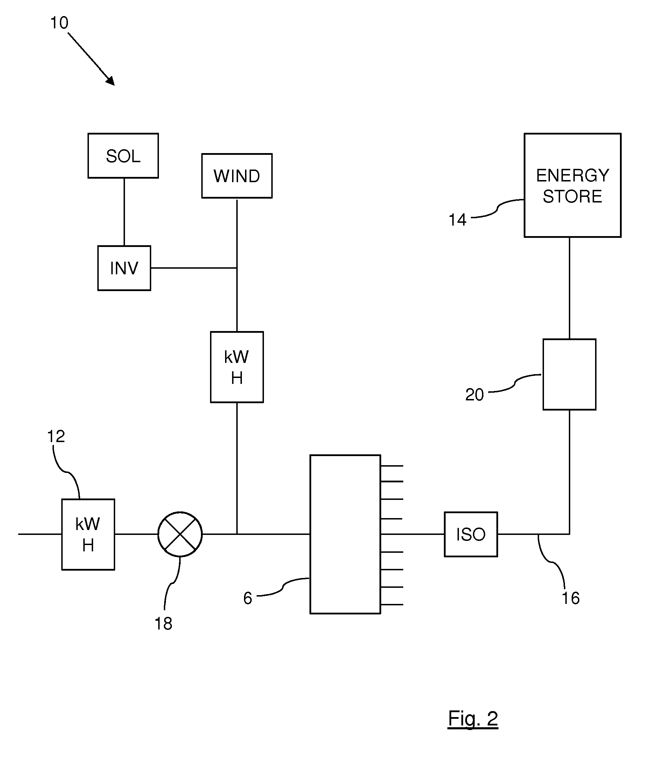

By using a single, low cost, non-invasive, wireless current sensor the cost reduces dramatically with a totally automatic solution within the existing infrastructure. Significant savings arise from the greatly reduced cost of installation and maintenance. Figure 2 shows the improved surplus power detection system that is for use in a power arrangement such as that provided in a home that has local power generation. Local power generators 10 provide power, as does the connection 12 to the general power grid. An energy load 14 is provided, which is an immersion heater. A network 16 connects the various components together. The surplus power detection system, in the preferred embodiment, is dedicated to automatically diverting the maximum amount of surplus, locally generated power to the energy load 14. In the power arrangement, the surplus power detection system achieves this by turning on the immersion heater 14 when the surplus power detection system senses that power is being exported to the external grid.

The surplus power detection system comprises two principal elements, a sensor 18 and a system manager element, the latter being provided in a main unit 20, which also includes a load control element. The sensor 18 provides the ability to detect the waveform of a current flow in real time, the load control element provides the ability to control a load on the system in real time and the system manager element provides the central intelligence, control and reporting that makes the elements into a complete system.

Many small installations already include immersion heaters or electric storage heaters. By using these existing forms of energy storage the cost of the system can be further reduced as no separate energy storage system will be required. Many systems require the power sensor to be wired into the Grid supply. If the energy store is not near the Grid connection it may also be necessary to add extra wiring and a means of isolation for the energy diversion equipment. Some power sensors may require calibration for the system to operate efficiently or at all. The non-invasive, wireless sensor 18 and automatic operation of the system eliminate all these issues and provide a reduction in the cost of installation that is significant enough to provide a return on investment. The non-invasive sensor 18 is one that just clips round a cable to measure power rather than requiring an electrical connection to be made. Such sensors exist but in their current form generally only measure current, not power. Wireless sensors enable the energy diversion device to be mounted where it can take maximum advantage of existing infrastructure rather than having to be near the sensor location. The wireless sensor 18 does not require batteries lowering costs even further. The use of algorithmic, adaptive control means the system is totally automatic. No calibration or special installation setup is required.

Basic installation with a wireless sensor using hot water as the energy store is straightforward and low cost. It is assumed that a local isolating switch for the energy store is already properly installed. For example, a typical installation would have an existing immersion heater with its own nearby, fused, double pole isolating switch. The installer should be a competent person as required for a domestic electrical installation. No plumbing knowledge is required as the existing immersion heater is used and so it is not necessary to drain the hot water cylinder. Only standard tools and consumables are required and the only complication is ensuring the wireless signal is available at the desired location. Otherwise, the installation should be capable of being carried out in a morning. The following steps are for a typical installation of the surplus power diversion system into an existing situation comprising a hot water cylinder and immersion heater:
1. Clip the current sensor 18 around the Grid meter phase conductor.
2. Check that its indicator is flashing to show that it is transmitting, if not, turn on a load such as a kettle so that the sensor starts harvesting energy.
3. Temporarily connect the new main unit 20 to a mains supply.
4. Identify a suitable location for the main unit 20 near the existing energy store isolating switch, where ventilation is available and it detects the sensor 18.
5. Disconnect the main unit 20 and isolate the immersion heater circuit.
6. Mount the main unit 20 at the selected location.
7. Disconnect the immersion heater from its isolating switch.
8. Connect the mains input terminals in the main unit 20 to the isolating switch.
9. Connect the mains output terminals in the main unit 20 to the immersion heater using the existing, heat resistant, flexible cable.
10. Reconnect the immersion heater circuit.
11. Turn on the isolating switch.

The system starts normal, automatic operation as soon as power is applied. Because of the capabilities of modern electricity meters how the storage load is controlled has an effect on the amount of electricity metered and hence the cost of the energy diversion system. This controls the amount of energy going into a load. The basic idea is to match the load to the amount of surplus energy being produced locally as using local energy is much more cost effective than using energy from the Grid. Ideally all local energy wants to be used or stored for later use and the amount of energy drawn from the Grid kept to a minimum. How the use of energy is metered and charged has a significant impact on the solution as a result of the 'instantaneous power' problem.

Historically, electricity meters have measured the amount of electricity consumed in one direction. The UK Government has mandated that in future all premises will use modern 'smart' meters. These modern meters can determine the direction of flow of electrical power over very small periods of time so that separate measurements can be taken of the amount of electricity that is being imported or exported to the Grid.

Electricity meters are used to provide a record of electrical power consumption and generation for the purpose of charging or rewarding the use of electricity. Historically they have just accumulated the amount of electricity consumed to arrive at a figure for the amount to be charged for any given time period. Modern meters can identify the direction of power flow and separately accumulate the amount of power flow in each direction.

In an installation that includes its own locally generated power, the direction of the power flow can change from consuming power to having excess generated power very rapidly, in fractions of a second. So how does the meter decide when electricity is being imported or exported? The meter has to measure the average flow over a given time period and then accumulate the net amount in that period as being either imported or exported.

Most metering standards mandate the minimum period over which average consumption can be netted but there is no maximum period. Depending on how the meter is designed this is quite critical if consumers' electricity bills are not to increase unexpectedly.

While there is surplus local power it will be exported to the Grid. If an extra load is connected to the system it will draw its rated power from the system. If the amount of surplus, local power is less than the extra rated load then the extra power required by the load will be drawn from the Grid. This is a basic law of physics.

The most common situation will be where the storage load is greater than the surplus power available. Using electronic methods it is quite simple to switch the load on and off for a few mains cycles at a time to match the average load to the surplus power. This means a single load can be used with the ratio of on-cycles to off-cycles varied as needed. For example, if the load is 3kW and the system is generating 1 kW of surplus power then by switching the load on for every third cycle it will appear, on average, to be a 1 kW load.

However, although the average load may be perfectly matched to the average surplus power, the instantaneous power usage is what affects metering.

Instantaneously power will either be drawn from or exported to the Grid. For example, when the 3kW load is turned on, it will consume 3kW of power. If the local generator only has 1 kW of surplus power then the difference of 2kW must come from the Grid. The local generator will provide 1 kW of power and the Grid will provide 2kW of power. When the 3kW load is turned off the surplus power of 1 kW will be exported to the Grid.

For one cycle, 2kW of power will be drawn from the Grid. For two cycles, 1kW of power will be exported to the Grid. Thus, over three cycles, 2kW of power will be drawn from the Grid and 2kW of power will be exported to the Grid. Thus, on average the amount of power drawn from the grid will be zero, as intended.

Older meters, such as the rotating disc variety, average the power consumed over several seconds and so, if the load is turned on and off rapidly, no extra power will be metered. The instantaneous power problem arises because modern meters are capable of sensing instantaneous power and can separately meter imported and exported power over short time periods measured in thousandths of a second. In the example above, a meter that nets or averages instantaneous power over one cycle would thus meter 2kW of power being exported to the Grid over the three cycles and meter 2kW of power being imported from the Grid over the same three cycles. As imported power is charged at a much higher rate than exported power the meter will effectively result in the consumer receiving an extra charge as a result of diverting the surplus power to local use.

It is quite likely that electricity utilities will adopt this design of meter as it will more accurately reflect their costs and provide higher revenue.

The best solution to match the load to the surplus power is reverse phase control. This works the same as standard phase control but turns off the device late in each mains supply half cycle to avoid many of the problems associated with non-resistive loads. Similar to the multiple cycle switching solution, during the part of the mains cycle when the load is turned on it will take its full rated power from the system drawing any amount in excess of the available locally generated power from the Grid. But, for the rest of the cycle, the available locally generated power will be returned to the Grid. As explained above, the amount drawn from the Grid and the amount returned to the Grid within a half cycle will be the same so that the net effect on the Grid power drawn is zero and, as this time period is less than the minimum period mandated by metering standards, the amounts drawn from the Grid and the amounts returned to the Grid will not be metered separately.

Thus, this method does not suffer from the instantaneous power problem.

MOSFETs (Metal Oxide Semiconductor Field Effect Transistors) or similar devices such as IGBTs (Insulated Gate Bipolar Transistors) are the best devices for implementing phase control. By controlling the gate drive the rate of rise or fall of load current can be controlled providing a low cost method of ensuring that the amount of EMI produced is within regulatory limits. The speed of response of these devices is fast enough that it is possible to use their turn-off capability to protect the device and circuit in the event of fault conditions. Additionally, the circuit can sense if there is no load connected And ensure the load waveform only alters in complete mains cycles, i.e. half cycles are identical, so no dc voltages are produced that could cause galvanic effects.

If power is being exported or imported to the Grid then this can be detected using a simple, single sensor. The local load can also be used to store the surplus power, but this does not have to be the case. For example, a light bulb could be turned on to determine whether there is surplus power available, but any surplus could then be diverted to an immersion heater or a battery store.

Although knowing the power factor enables direct measurement of the instantaneous surplus power, actually diverting this precise amount of power is not straightforward as this requires detailed knowledge of the connected storage load. The storage load will vary for each installation. Even if the initial load characteristics can be determined during initialisation they may vary over time or with the amount of energy stored. Thus, for fully automatic operation the amount of power being diverted to the storage load would need to be measured directly. Such a measurement needs to be obtained by a sensor that is isolated from the mains supply and easily installed. Effectively one would need another power sensor like the one used for the Grid connection. But this is an expensive addition as it now requires two sensors.

Fortunately, knowing the direction of power flow enables the use of a closed loop feedback system to gradually divert energy to the storage load and reduce the Grid current. Only a single, simple sensor is required. There is no need to use sensors that measure current and voltage or for accurate calibration of the sensor. The sensor 18 simply clips around the cable from the main Grid meter or peripheral device whose power usage is to be monitored. In this way, the system becomes fully automatic and continuously adapts to changing conditions without incurring extra costs. This is because an adaptive approach does not require any intelligence or a high accuracy in the sensor as continuous feedback ensures the system will closely approach the desired operating state.

When power is being exported to the grid then the device diverts more power for local use such as charging up a local energy store. If power is being imported from the Grid then the device diverts less power for local use. The device tracks the amount of excess local power being produced by continuously evaluating whether power is being imported or exported to the Grid and will settle around the optimum point where the maximum power is diverted to the local load without reaching the point where power is drawn from the Grid. Significantly, the local load to use the surplus power can be selected as desired without affecting the general operation of the system. To achieve this mode of operation, the sensor only needs to be able to accurately determine the direction of Grid power flow, the magnitude of the flow is important but not critical. Thus, by using combined algorithmic and power factor sensing and an adaptive control method the desired objective of a low cost system can be achieved.

The system comprises three main components, the current sensor 18, a system manager and a load controller. The system manager and load controller will both be contained in the same main unit 20. When all the components are working together the system will have inputs and outputs managed by the system manager.

The key control input to the surplus power detection system is the magnitude, timing and polarity of the current flowing to or from the Grid. The first part of the system is the current sensor 18 mounted by the Grid meter. It comprises a current transformer that measures the magnitude of the current flowing through the cable to which it is clipped and a sensing circuit to convert the output of the current transformer into a form suitable for use by the rest of the system. The current sensor 18 is self-powered; it gets the very small amount of energy it needs from the current transformer it uses to sense the current flow. The values measured by the sensor 18 are transmitted over a wireless link to the main unit 20, which contains the system manager component. The sensor 18 does not need to transmit continuously. This minimises the energy it requires to operate and the main unit 20 gets no benefit from continuous readings. However if a large current increase is detected due to for example turning on a kettle, then the change is sent straightaway to minimise any time lag in response. The design of the main unit 20 means that there is no need for the sensor 18 to know the direction of the power flow, only the current magnitude, its timing and polarity. The normal mains electricity supply is the power input to the main unit. The power is mainly used by the load controller to control the amount of power going to the controlled load but a small amount is used to power the system manager. The power input provides the system manager with a reading of the system voltage that it uses with the measurements it receives from the sensor to determine the power factor at the sensing point.

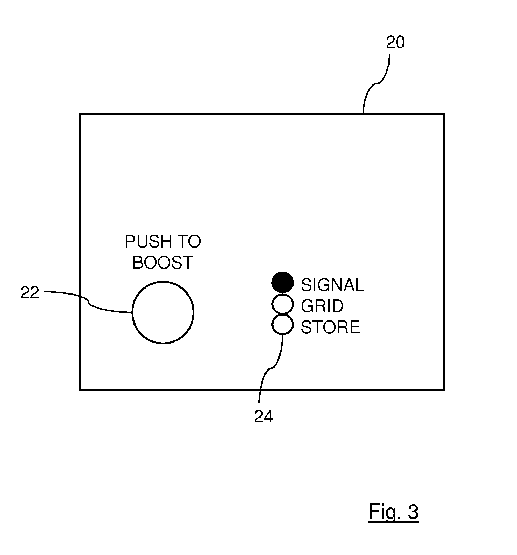

The main unit 20 has a set of three terminals (phase, neutral and earth) to connect it to the mains electricity supply to the energy store. It is effectively inserted into the supply to the energy store which is now connected to one of the outputs of the main unit 20. A key use of the system is to divert surplus power to an energy store 14. To facilitate this mode of operation, when the load is an energy store, the main unit 20 has a 'boost' push button 22, see Figure 3. It is the only user operated control on the main unit 20. Alternate presses of the button toggle the device between normal automatic mode and 'boost' or 'always on' mode. The operation of this control can be overridden by the 'demand satisfied' control input. Using the control is also a very effective and simple self-test facility, meaning that if all is well, then pushing the button so the unit enters 'boost' mode will immediately cause an indicator to come on.

In automatic mode the system manager gradually turns on the output to the energy store 14 by an amount required to utilise the locally generated power that would otherwise be exported to the Grid. It will not use power drawn from the Grid. In 'boost' mode the device turns its output full on so the load draws the maximum amount of power that it can from the mains supply, even if this requires extra power to be taken from the Grid. If the load is an existing immersion heater, this provides what was previously the normal operation of the heater. For a more sophisticated form of load, such as an energy store, it provides a means of initially charging the store.

A 'demand satisfied' control input shuts down the load output of the main unit 20. The main unit 20 has two, volt free terminals for connecting an external, mains electricity voltage control signal. When mains voltage is present, the output of the main unit 20 is effectively shut down. It is used to prevent further power being diverted to a full energy store, e.g. water temperature is at maximum, even if there is locally generated power available. Any energy store will suffer losses so a small amount of power can be allowed to go to the energy store even when it is shut down. This allows the rest of the device to continue to operate normally. The output will continue to have very small increments of power sent to it in order that the device can monitor correct operation of the sensor.

A water temperature input allows the system to report current water temperature. This could allow the system to check for conditions that may be conducive to Legionella development and produce a warning or run a hot cycle as required. The main unit 20 has two, volt free terminals for connecting an external thermistor temperature sensor. A thermistor based temperature sensor is attached to the hot water cylinder and makes the water temperature available to the system on a continuous basis.

The main unit 20 has a set of two larger terminals (neutral and earth) and multiple smaller (phase) terminals. One of the phase terminals is designated as the main output. This output terminal is also controlled by the 'demand satisfied' control input and is used where the load is an energy store.

The other phase terminals can be connected to loads that do not require any 'demand satisfied' override but will receive any surplus power available. All loads must be capable of receiving phase controlled power without damage. The output from the control section is one that will energise the phase output terminals locked to the mains frequency. This output must be connected to a load with a minimum rating (to be specified) to ensure that it can be used to allow correct operation of the system. The output stage phase controls the power at the output terminals to provide the required load to match the amount of surplus power available from local generation.

The main unit 20 is provided with LED indicators 24, as shown in Figure 3. The main purpose of the indicators 24 is to feedback the basic state of the system to the user: system on - the system has power, no sensing - the wireless link is not working, output on - power is being provided to the energy store, boost - the store is being charged whether or not excess power is available, demand satisfied - the store cannot accept any more energy and system error - an error condition has been detected.

As the main unit 20 already contains a wireless capability, a tablet or smart phone acts as a remote display panel for more detailed information from the main unit 20 such as estimated totals of power generated, diverted and used from the Grid. It will also contain the necessary controls for remotely putting the system in boost mode and even show water temperature, a facility lacking in the vast majority of existing installations. LEDs are the lowest cost means of basic indication. Single on/off indicators could be used but for further cost reduction it is possible to use multi-mode indication such as multicoloured LEDs or by each indicator having several possible modes such as off, slow pulse, on solid and fast flash. On initial power up, all indicators 24 light on solid for six seconds as a self-test.

The main error indication required will be that there is no wireless connection as this is essential to commissioning the device. As these are error states it is required that they are clearly identifiable as such to the User. Two standard methods for achieving this are to use a red colour or a fast flash both of which impart a degree of urgency and should only ever occur if user action of some sort is expected. Various combinations of indications are possible, for example;

| | **Off** ○ | **On Solid** 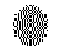 | **Fast Flash** 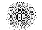 |
|---|---|---|---|
| 1-Supply | No Supply | Power on | Internal Error |
| 2-Store | No Output | Storing | No Load/Overload |
| 3-Full | Store Available | Demand Satisfied | On Boost |
| 4-Link | Wireless Active* | Registering | No Radio Link |

| | | | |
|---|---|---|---|
| * For more sophisticated feedback this could be a short on period, say a half second, corresponding to the actual sensing transmission being received. | | | |

However, a system that provides detailed information by means of a tablet device connected via a gateway of hub can have fewer indications on the system manager. The main indication required will be to show the state of the wireless connection as this is essential to commissioning and operation of the device;

| **LED** | **Off** ○ | **Magenta** 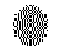 | **Blue On** 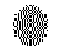 | **Flashing Blue** | **Red On** 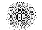 | **Flashing Red** 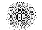 |
|---|---|---|---|---|---|---|
| **1-Signal** | System Off | | System Working | Message Received | No Signal | No Registered Sensor |
| **2-Grid** | Importing | Changing Conditions | Diverting | Exporting | System Error | No Key Sensor |
| **3-Store** | Auto | | Store Full | Boost | No Store | Overload Fault |

These indications will apply whether or not a hub or gateway is in use. The message received indication does not involve the LED being off as this could also be mistaken for the off state. The no signal indication will only occur when the watchdog process has determined that no messages are being received from the key sensor.

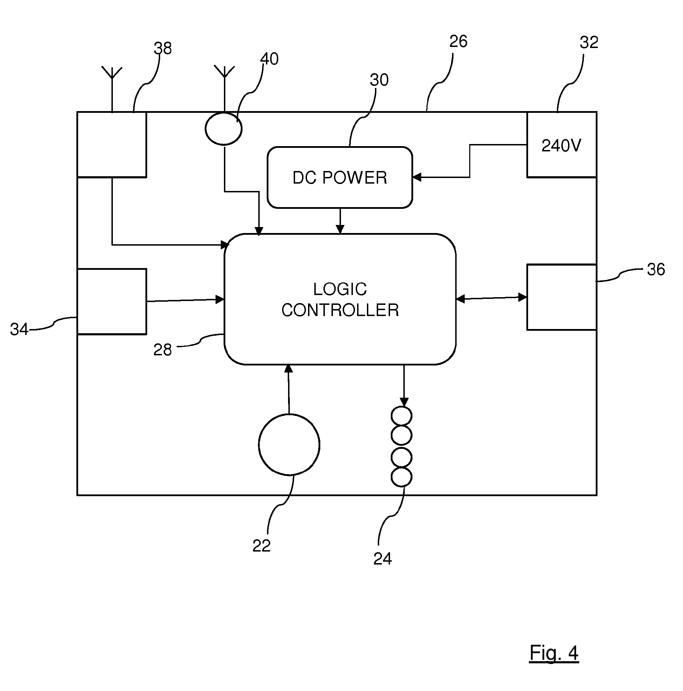

The system manager 26, shown in Figure 4, contains all the user controls and indicators. The system manager 26 is responsible for decoding the various inputs to the system and producing the various intermediate values and the output to drive the load controller phase control output stage. The system manager 26 has two key functions: to ensure the system remains stable and to carry out the adaptive control described above.

The system manager 26, in a preferred embodiment, is a firmware implementation of logic and is provided with a logic controller 28. The system manager 26 is provided with a DC power supply 30, which is powered from a mains connection 32. The sensor 18 is connected to the system manager 26 by a sensor connection 34. On the output side, the system manager 26 is connected to one or more local loads through the output connections 36. The system manager 26 is also provided with a wireless system 38 for the sensor and a Wi-Fi connection 40 (optional). The logic controller 28 of the system manager 26 is also connected to the push button 22 and the LED indicators 24.

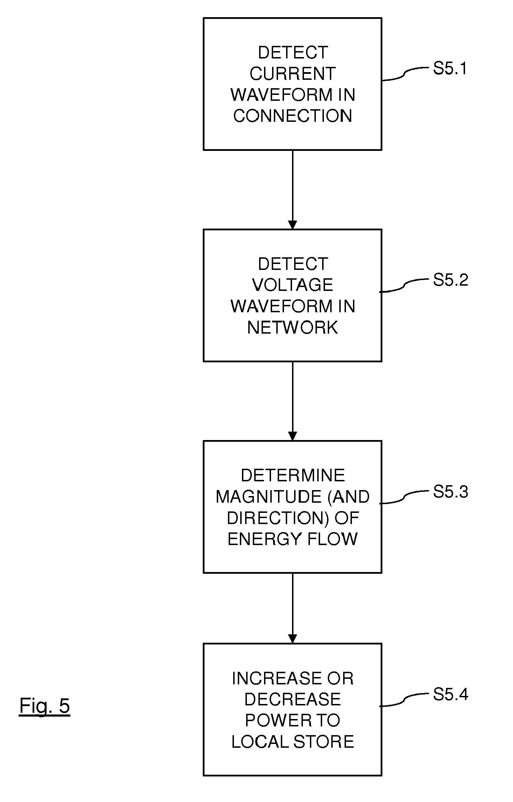

Figure 5 shows the principal method of operating the power measurement system. The sensor 18 will detect the current waveform in the connection 12 to the general power grid at step S5.1, and the system manager 26 will detect the waveform of the voltage in the network 16 at step S5.2. After receiving the detected current waveform and timing information for the current waveform from the sensor 18, the system manager will determine the magnitude (and direction) of the real power flow in the connection 12 to the general power grid from the detected current waveform and the detected voltage waveform, at step S5.3. The power diverted to the local energy load 14 will be increased by the determined magnitude if the determined direction of power flow in the connection 12 to the Grid is in the direction of the Grid, at step S5.4.

Figure 5 illustrates the system in the context of surplus power capture system, which uses the sensor 18 to determine if power is being exported to the Grid and also how much power is being exported. This is then diverted to the local load 14 (see Figure 2). However the broad concept is that the sensor 18 is able to be used to make an accurate calculation of the real power being consumed at that connection, in conjunction with the system manager 26. The sensor 18 could be simply fixed to the connection to an electric oven, for example, in order to accurately determine the power being consumed by that connection. In this case, the step S5.4 is optional, as the central purpose of the method if to calculate the real power in the connection (whatever that information is then used for).

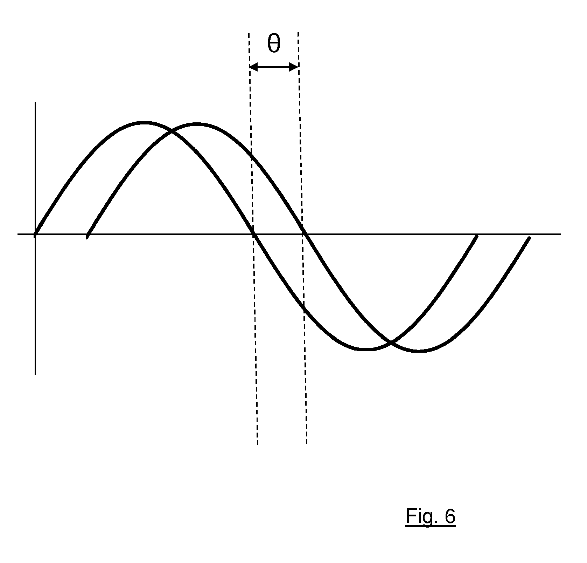

Figure 6 illustrates the concept of phase angle in an AC signal, which is used in the calculation of both the magnitude and the direction of the power flow in the connection to which the sensor 18 is connected. In a typical AC power system, the current and voltage will be out of phase, as illustrated in Figure 6 by θ. Since power is calculated from the current and voltage, to calculate real power (as opposed to an approximation) the phase angle (the extent of the phase difference) needs to be known. This is achieved by measuring the current waveform with timing information at one location and measuring the voltage waveform at a second location. With these three pieces of information, real power can be calculated as can the direction of the energy flow in the connection where the sensor 18 is located. The principal advantage of splitting the system in this way is that an accurate power measurement can be made at the location of the sensor 18, without requiring a complex and expensive sensor. The system manager 26 is arranged to detect the direction of the energy flow in the connection 12 from the timing difference between the detected current waveform in the connection 12 and the detected voltage waveform in the network 16.

In practice the current waveform is not as ideal as the Figure suggests. Thus the waveforms are sampled and the instantaneous power, being the instantaneous current with a known polarity multiplied by the instantaneous voltage, is calculated for each sample. By integrating the results over a defined period the real power and apparent power over the period are calculated and the effective phase angle and direction of power flow determined.

The system has four operational states: tracking, stable, sleep and override (boost or demand satisfied). In addition, the system has two transitional states: initialisation and watchdog.

The tracking state is the ideal state where the maximum amount of power is being diverted for local use. The system is adjusting continuously to track the amount of surplus power so that there is a low net export of power. Although the sensor 18 measures the magnitude of the current flowing through the Grid connection the main unit 20 calculates the real power flow thus ensuring that as much as possible of the local power being generated is used locally.

The stable state is when the system is clearly in a state where power is neither being exported nor imported and will continue to remain in that state unless a major change occurs. Generally, the load on the electrical system and the power generated do not fluctuate wildly. In a stable state, the Grid current will not change significantly. This state can be detected by the sensor and measurements only sent to the main unit 20 when changes occur. This reduces the power requirements of the sensor 18 thus facilitating the use of a sensor with no batteries.

The sleep state is when an unpredictable event has happened and the system has not yet determined whether or not power is being exported or imported. The override state is when an external control signal has mandated the output state regardless of the sensor readings. The initialisation state occurs when the unit is powered up and is the state in which wireless registration occurs.

A fault or other undetected change may cause the system to stay in the sleep state. The system must therefore periodically check that there has not been an undetected change, this is the watchdog state. The main unit 20 may not receive a current measurement from the sensor 18 for extended periods. For example, the system is likely to be in a stable state for long periods at night. Therefore the system manager 26 momentarily turns on the local energy store to ensure that there is sufficient Grid power flow for a self-powered sensor. The resulting current change will cause the sensor to send measurements as necessary to enable the system to detect fault states.

When the system is running, the core process is to track the amount of surplus power being generated locally. When this occurs either too much power can be diverted to the energy store leading to the unnecessary use of Grid power or too little can be diverted to the energy store leading to the unnecessary export of power that could be used locally. Both conditions will potentially reduce the overall efficiency of the system.

Therefore, to increase the system efficiency, adapting to changes needs to be carried out quickly but infrequently. A fully optimised system would tend to settle at the point where there is no Grid current. It is anticipated that the loss in system efficiency can be kept to less than 2% of the overall power diverted to the store.

Initially, power flow readings will be taken a fixed, short time interval apart, say every ten seconds. But when the system is in a sleep or stable state the readings can be taken at longer intervals. In this way, the sensor power requirements are dramatically reduced allowing it to be powered by energy harvesting. When a wireless sensor is used the availability of harvested energy will automatically determine the reading interval.

The sensor element defaults to taking a set of two readings and then waits until enough energy has been harvested to take another measurement or ten seconds whichever is longer. The optimum state is when Grid power flow is near zero. During such stable conditions the sensor can increase the interval between each set of two readings significantly to several minutes.

A local power system is subject to sudden and unpredictable changes in load, e.g. an electric kettle or other appliance being turned on as well as sudden changes in generation, e.g. the passing of a cloud. Such a change will ensure the sensor can harvest energy and result in an immediate reading and system response. When there is a sudden change to the system there will be a large, one-off, unexpected change to the Grid current. This will be followed quite quickly by a return to the stable state.

Various techniques can be used to accelerate this process. One of these is to run the watchdog process if the system has remained in a tracking state for a long period of time. This enables a new, potentially more accurate tracking state to be established. As the real power flow is now known it also enables the amount of energy to be diverted to be rapidly increased to the desired level.

If the system is subject to continuous shocks, e.g. during a thunder storm, it is possible that the controller is unable to reach a stable state for some time. This would be an unstable system. In these circumstances, the controller must cease diverting power to the load until stability returns.

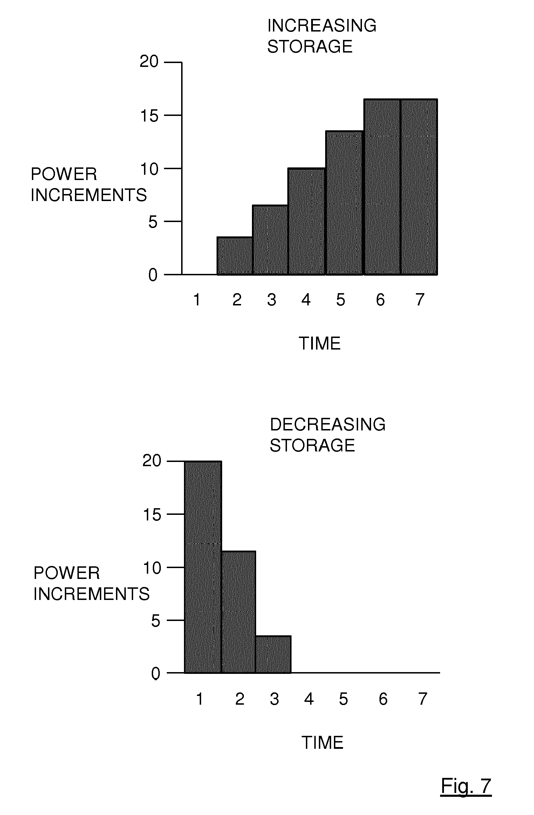

The system will measure the magnitude of any change to the Grid power and, in theory, could adjust the amount of energy diversion to exactly match the change. In practice this would lead to an unstable, under damped system. By changing the amount diverted as a proportion of the change the system will have a built-in lag to enhance stability. The proportion used can be varied depending on whether the change requires an increase or decrease in the amount diverted. In this way the rate of increase in diversion of power to the energy store can be slower than the rate of decrease thus biasing the system to less use of Grid power and increasing system efficiency, as shown in Figure 7. In an accelerated sensing cycle the sensor element will send a measurement whenever it detects a significant change in Grid current flow.

The sensor 18 and the main unit 20 can be incorporated in a building control system. Current solutions that have the capability to deal with locally generated power or smart meter technology have had to adapt by creating new, more capable components as and when needed. Though, although these solutions appear to be available on a modular basis they are actually proprietary, legacy systems designed on a complete or bespoke system basis.

As well as embracing modern concepts a new system will need to embrace modern standards many of which are still in a formative stage. Finally, the capabilities of modern technology are changing rapidly so new systems will need to be able to allow the easy addition and integration of new features.

The new sensor 18 is one of a range of modules that need to work together to produce a modern, flexible system with an emphasis on communication. It provides the capabilities that are missing from legacy systems such as the ability to communicate over wireless and be part of a system integrated with the Internet but in particular be able to sense not only real power but also the direction of power flow. The latter is a good example of a new requirement necessitated in a changing world by the introduction of local power generation in systems that are also connected to and can export surplus power to a central power source such as the National Grid in the UK.

The remote sensor technology already developed is a method for collecting energy related information. The other elements required to start making complete systems are a load controller and a system manager. The sensor provides the ability to measure the magnitude and direction of a power flow in real time, the load controller provides a controlled mains supply to a connected load and the system manager provides the central intelligence, communications and reporting that makes all the elements into a complete system. These elements can be produced in volume to reduce costs and used as part of a more comprehensive, modern building management control system.

The sensor 18 provides the specialist capability not readily available elsewhere to remotely measure both real power and power flow direction. This addresses a significant part of the sensing requirements for a building control system that cannot be satisfied by using other, readily available parts. Being a wireless sensor makes deployment easy and it can be used to monitor power flow at peripheral loads, generating sources or the connection of the system to the Grid. This will provide the system manager with extra data so that it is ideally placed to report back to a central monitoring point and to react to instructions from that point for control of detailed elements of the building based on centrally determined criteria such as energy tariffs.

The system manager allows reporting and remote control over the internet or locally by connecting a tablet or smartphone to the system manager via a gateway. If the gateway can also act as a central hub then it will enable the range of the system to be easily extended. Sensors and actuators can all communicate via the hub thus potentially doubling the distance that can be achieved between any particular sensor and actuator.For example, if the main unit and grid sensor can operate up to a distance of 10 metres apart then by interposing a hub between them they can then potentially operate up to a distance of 20 metres.

The system is also then easy to expand. For example, initially a sensor and system manager in a local generation system can provide low cost sensing of power flow to and from the Grid. By adding a load controller this can expand to provide automatic diversion of locally generated, surplus power to a local energy store. At a later date, as the UK smart meter project is rolled out, energy costs can be accessed allowing the system to optimise energy usage and security, heating, smart appliances and other building management features can be added to provide a complete house controller accessible over the Internet.

With the emphasis on wireless operation it is desirable that as few components as possible require a mandatory connection to the mains supply. The only components requiring a mains supply connection are the system manager, which always needs to be active, and any unit that controls power output such as a power diversion device that provides power to a local, storage load. The proposed system design is to have the system manager and associated communications facilities as a standalone module that only requires a low voltage supply. As a modern, digitally based system it is easy to provide the ability to identify loads for reporting and control. This is because each sensor has a unique address for communications. All sensor and load control elements can have bi-directional communication with the system manager. Although use of the IP (Internet Protocol) over WiFi is becoming generally available, it may not be best suited to control and monitoring of loads. Many loads will have issues with providing the power required to maintain an IP link, access to a wired cable for the link or be too cost sensitive to provide an IP standard WiFi link. In addition, the central processing power required to maintain such links can become prohibitive as the quantity of links increases. The new concept provides a System Manager element that forms an interface between low cost wireless solutions for peripheral loads and the need to provide IP based identification and communication to enable real time control and communication with wider area systems.

The cost of providing this ability by wireless is relatively high compared to having a simple, physical connection between the components but results in a greater reduction in the cost of installation. Wireless sensors enable feedback of data on the state of other, individual, peripheral devices that will be essential to provide central building control.

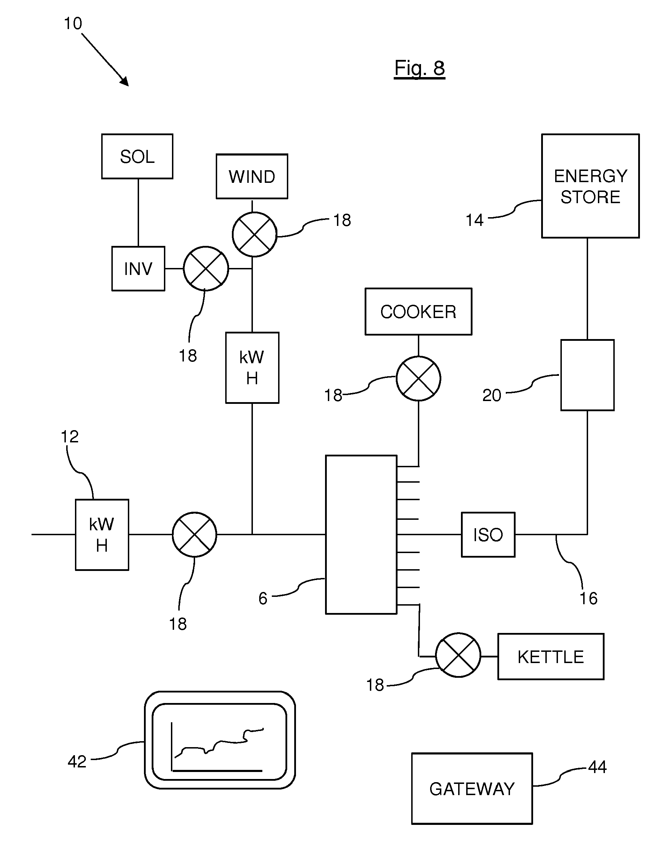

Figure 8 illustrates an example of a building control system, which uses multiple sensors 18, all of which are in contact with the main unit 20. Each sensor 18 measures the current waveform locally and sends that information with timing information to the main unit 20. The system manager 26 within the main unit 20 is able to calculate the voltage waveform and can therefore work out the real power consumed at each of the sensors 18. A tablet 42 is provided that a user can interface with in order to access the information about power consumption within the home represented in Figure 8. A gateway 44 is provided which provides a link between the sensors 18 and the main unit 20, thereby doubling the effective distance between the sensors 18 and the main unit 20. The main unit 20 communicates wirelessly with the tablet 42 through the gateway 44 and provides all of the power consumption information via a suitable user interface to the user. The gateway 44 is arranged to communicate with the sensor 18 and the system manager 26 of the main unit 20.

## Claims

1. A power measurement system comprising:
o a sensor (18) arranged to detect the waveform of the current in a connection (12) and to transmit the detected current waveform and timing information for the current waveform, and
o a system manager (26) arranged to receive the detected current waveform and timing information for the current waveform, detect the waveform of the voltage in a network (16), and determine the magnitude of the energy flow in the connection (12) as a real power measurement from the detected current waveform in the connection (12) and the detected voltage waveform in the network (16).

2. A system according to claim 1, and further comprising a gateway (44) arranged to communicate with the sensor (18) and the system manager (26).

3. A system according to claim 1 or 2, wherein the system manager (26) is further arranged to detect the direction of the energy flow in the connection (12) from the timing difference between the detected current waveform in the connection (12) and the detected voltage waveform in the network (16).

4. A system according to claim 1, 2 or 3, wherein the sensor (18) is connected to the system manager (26) via a wireless connection.

5. A system according to any preceding claim, wherein the sensor (18) is self-powered and is arranged to take the power it requires from the connection (12).

6. A system according to any preceding claim, wherein the sensor (18) is connected non-invasively to the connection (12).

7. A system according to any preceding claim, wherein the system manager (26) is further arranged to increase the power diverted to a local energy load (14) according to the magnitude of the energy flow in the connection (12).

8. A system according to claim 7, wherein the system manager (26) is arranged to change the power diverted to the local energy load (14) by a defined amount.

9. A system according to claim 7 or 8, wherein the system manager (26) further comprises a user interface component to switch the system manager (26) to a boost mode where the system manager (26) increases the power diverted to the local energy load (14) to the maximum possible.

10. A system according to any claim 7, 8 or 9, wherein the local energy load (14) comprises a local energy store (14).

11. A system according to any preceding claim, wherein the system manager (26) is further arranged to measure the mains frequency of the voltage in the network (16) and adapt the timing information accordingly.

12. A power measurement method comprising:
o detecting the waveform of the current in a connection (12) with a sensor (18),
o transmitting the detected current waveform and timing information for the current waveform,
o receiving the detected current waveform and timing information for the current waveform at a system manager (26),
o detecting the waveform of the voltage in a network (16), and
o determining the magnitude of the energy flow in the connection (12) as a real power measurement from the detected current waveform in the connection (12) and the detected voltage waveform in the network (16).

13. A method according to claim 12, and further comprising detecting the direction of the energy flow in the connection (12) from the timing difference between the detected current waveform in the connection (12) and the detected voltage waveform in the network (16).

14. A method according to claim 12 or 13, and further comprising increasing the power diverted to a local energy load (14) according to the magnitude of the energy flow in the connection (12).

15. A method according to claim 14, wherein the step of increasing the power diverted to the local energy load (14) comprises using phase control to change the power diverted to the local energy load (14) by a defined amount.
